# EUROPÄISCHE PATENTSCHRIFT

(11) **EP 1 176 632 B1**
(45) Veröffentlichungstag und Bekanntmachung des Hinweises auf die Patenterteilung: **13.04.2005**
(21) Anmeldenummer: 01114834.3
(22) Anmeldetag: 28.06.2001
(51) Int. Cl.: H01L 21/306, B08B 3/08

(54) **Verfahren zur chemischen Behandlung von Halbleiterscheiben**
Process for chemical treatment of semiconductor wafers
Procédé de traitement chimique de substrats semiconducteurs

(30) Priorität: 27.07.2000 DE 10036691
(43) Veröffentlichungstag der Anmeldung: 30.01.2002
(73) Patentinhaber: Siltronic AG, 81737 München (DE)
(72) Erfinder: Brunner, Roland, 84367 Reut (DE)
(74) Vertreter: Rimböck, Karl-Heinz, Dr.

(56) Entgegenhaltungen:
- EP-A- 0 700 077
- EP-A- 0 708 480
- EP-A- 0 782 177
- PATENT ABSTRACTS OF JAPAN vol. 016, no. 360 (E-1243), 4. August 1992 (1992-08-04) -& JP 04 113620 A (SEIKO EPSON CORP), 15. April 1992 (1992-04-15)
- TARDIF F ET AL: "Optimization of HF last and oxidant wet cleanings for 7 nm gate oxide" MICROELECTRONIC ENGINEERING, ELSEVIER PUBLISHERS BV., AMSTERDAM, NL, Bd. 28, Nr. 1, 1. Juni 1995 (1995-06-01), Seiten 121-124, XP004011866 ISSN: 0167-9317
- PATENT ABSTRACTS OF JAPAN vol. 2000, no. 07, 29. September 2000 (2000-09-29) -& JP 2000 100777 A (DAINIPPON SCREEN MFG CO LTD), 7. April 2000 (2000-04-07)
- PATENT ABSTRACTS OF JAPAN vol. 012, no. 049 (E-582), 13. Februar 1988 (1988-02-13) -& JP 62 198127 A (SANYO ELECTRIC CO LTD;OTHERS: 01), 1. September 1987 (1987-09-01)

## Beschreibung

Die Erfindung betrifft ein Verfahren zur chemischen Behandlung von Halbleiterscheiben in Gegenwart von HF und im Anschluß daran in Gegenwart von Ozon, insbesondere zur Reinigung von Halbleiterscheiben aus Silicium.

Verfahren zur naßchemischen Behandlung von Halbleiterscheiben sind bereits bekannt. Hierzu sei beispielsweise auf DE-A 19853486 sowie auf US-A 5,662,743 verwiesen, die es sich zum Ziel gesetzt haben, Halbleiterscheiben von metallischen Verunreinigungen und Partikeln zu befreien. Die genannten Verunreinigungen stören im allgemeinen bei der Oberflächenstrukturierung.

In der JP-A-4 113 620 ist einer naßchemischen Behandlung von Halbleiterscheiben beschrieben, bei der die Scheiben mit HF- und dann mit einer Ozonlösung behandelt werden.

Gegenstand der Erfindung ist ein Verfahren gemäß des Patentanspruchs.

Durch die vorliegende Erfindung wird ein Verfahren zur Verfügung gestellt, mit dem Halbleiterscheiben besonders effektiv konditioniert werden können für ein defektfreies Aufwachsen thermischer Oxide.

Bei dem im erfindungsgemäßen Verfahren eingesetzten HF-haltigen Medium handelt es sich um eine wässerige HF-Lösung, die HF in einer Konzentration von 0,001 bis 10 Gew.-% enthält. Des weiteren kann die erfindungsgemäß eingesetzte wässerige HF-Lösung HCI in einer Konzentration von 0,001 bis zu 10 Gew.-%, bevorzugt 0,2 bis 2,0 Gew.-%, enthalten. Das erfindungsgemäß eingesetzte HF-haltige Medium enthält außer HF, gegebenenfalls Wasser und gegebenenfalls HCI bevorzugt keine weiteren Stoffe, wie beispielsweise Tenside.

Bei dem im erfindungsgemäßen Verfahren eingesetzten ozonhaltigen Medium handelt es sich um eine wässerige O₃-Lösung, die O₃ in einer Konzentration von 1 bis 50 ppm enthält.

Die wässerige HF-Lösung und/oder wässerige Ozon-Lösung werden bevorzugt mit deionisiertem Wasser bereitet.

Bei dem erfindungsgemäßen Verfahren schließt sich die Behandlung mit dem ozonhaltigen Medium direkt an die Behandlung mit dem HF-haltigen Medium an, ohne zusätzlichen Spülschritt mit Wasser. Das Weglassen einer Spülung mit Wasser zwischen den Behandlungen mit den chemisch wirksamen Agenzien ist schon aus ökonomischer Sicht von Vorteil und verbessert die Reinigungswirkung an der Si-Oberfläche wesentlich. Außerdem wird durch das erfindungsgemäße Verfahren die oxidierende Wirkung von Ozon an der Si-Oberfläche verbessert.

Die im erfindungsgemäßen Verfahren eingesetzten Halbleiterscheiben, die mit einem HF-haltigen Medium behandelt wurden und frei von wässerigem HF sind, werden nach erfolgter Behandlung im wässerigen HF-Bad von diesem in der Weise getrennt, daß sich kein wässeriger HF mehr an der Oberfläche der Halbleiterscheibe befindet.

Bei dem erfindungsgemäßen Verfahren werden die behandelten Halbleiterscheiben aus dem wässerigen HF-Bad mit einer Geschwindigkeit von 0,01 bis 15 mm pro Sekunde durch die Oberfläche der wässerigen HF-Lösung, vorzugsweise mit einer automatisierten Handlingsvorrichtung, gezogen. Die so erhaltenen Halbleiterscheiben, die frei von HF-Lösung sind, werden dann im Anschluss in das nachfolgende ozonhaltige Medium getaucht und gleichmäßig hydrophiliert.

Das erfindungsgemäße Verfahren wird bei einer Temperatur von vorzugsweise 10 bis 65°C, besonders bevorzugt 20 bis 30°C, und einem Druck von bevorzugt 900 bis 1100 hPa durchgeführt.

Der erfindungsgemäßen Behandlungsfolge können - falls erwünscht - weitere für die chemische Behandlung von Halbleiterscheiben übliche Schritte vor- bzw. nachgeschaltet werden, wie beispielsweise eine Trocknungsbehandlung der Halbleiterscheiben nach erfolgter Ozon-Behandlung.

Das erfindungsgemäße Verfahren hat den Vorteil, daß das native Oxid auf der gesamten Si-Oberfläche der Halbleiterscheibe während der Ozonhydrophilierung sehr gleichmäßig aufwächst. Das Oxid enthält vorteilhafterweise keine defekten Stellen im nativen Oxid, die eine ungleichmäßige thermische Oxidation im nm-Bereich bewirken. Entsprechend der Anforderung der Weiterverarbeitung in der IC-Industrie werden sehr dünne oder dicke Oxid-Layer auf die Halbleiterscheibe aufgebracht. Die thermisch erzeugten Oxid-Layer wachsen gleichmäßig und ohne defekte Bereiche auf.

Des weiteren hat das erfindungsgemäße Verfahren den Vorteil, daß die Si-Oberfläche der Halbleiterscheibe frei von Bereichen mit unterschiedlichen Microrauhigkeiten (Haze) ist, die durch Reste wässriger HF-Lösung in Verbidung mit wässriger Ozon-Lösung entstehen.

### Beispiel 1

50 Silicium-Halbleiterscheiben mit einem Durchmesser von jeweils 200 mm wurden in 50 1 wäßrige HF-Lösung mit einer HF-Konzentration von 0,2 Gew.-% getaucht und nach einer Dauer von 5 Minuten mit einer Ziehgeschwindigkeit von 0,5 mm/s aus der HF-Lösung gezogen. Anschließend wurden die so erhaltenen Halbleiterscheiben für eine Dauer von 5 Minuten in 50 1 wäßrige Ozon-Lösung mit einer Ozonkonzentration von 6 ppm getaucht.

Die so behandelten Halbleiterscheiben wurden nun einer an sich bekannten thermischen Poly/LTO-Oxidation unterzogen. Die Beurteilung der Qualität der Oxidgleichmäßigkeit erfolgte mit einer visuellen Kontrolle unter Haze-Licht. Der Anteil der Halbleiterscheiben mit ungleichmäßigen Oxidflächen war in etwa gleich 0.

### Vergleichsbeispiel 1

Die in Beispiel 1 beschriebene Arbeitsweise wird wiederholt mit der Abänderung, daß die Ziehgeschwindigkeit der Halbleiterscheiben aus dem HF-Bad anstelle von 0,5 mm/s 50 mm/s betrug.

Der Anteil der Halbleiterscheiben mit ungleichmäßigen Oxidflächen, vorzugsweise an den Stellen, an denen HF-Lösung vor dem Tauchen in Ozon-Lösung an den Halbleiterscheiben haftete, war im 80%-Bereich.

## Patentansprüche

1. Verfahren zur chemischen Behandlung von Halbleiterscheiben zu deren Konditionierung vor einer thermischen Oxidation, mit folgenden Schritten:
- Behandlung der Halbleiterscheiben mit einer wässerigen HF-Lösung;
- Trennung der mit HF behandelten Halbleiterscheiben von dem wässerigen HF-Bad und anschließend
- Behandlung der Halbleiterscheiben mit einer wässerigen O₃-Lösung, die O₃ in einer Konzentration von 1 bis 50 ppm enthält;
**dadurch gekennzeichnet, daß**:
- die wässerige HF-Lösung HF in einer Konzentration von 0.001 bis 10 Gew.-% enthält;
- die Trennung der mit HF behandelten Halbleiterscheiben vom wässerigen HF-Bad dadurch erfolgt, daß die behandelten Halbleiterscheiben mit einer Geschwindigkeit von 0.01 bis 15 mm pro Sekunde durch die Oberfläche der wässerigen HF-Lösung gezogen werden, so daß sich kein wässeriger HF mehr an der Oberfläche der Halbleiterscheiben befindet; und daß
- die Halbleiterscheiben anschließend thermisch oxidiert werden.

## Claims

1. Process for the chemical treatment of semiconductor wafers to condition them prior to a thermal oxidation, comprising the following steps:
- treatment of the semiconductor wafers with an aqueous HF solution;
- separation of the semiconductor wafers treated with HF from the aqueous HF bath and subsequently
- treatment of the semiconductor wafers with an aqueous O₃ solution comprising O₃ in a concentration of from 1 to 50 ppm;
**characterized in that**:
- the aqueous HF solution comprises HF in a concentration of from 0.001 to 10% by weight;
- the semiconductor wafers treated with HF are separated from the aqueous HF bath by being drawn at a speed of from 0.01 to 15 mm per second through the surface of the aqueous HF solution, so that there is no longer any aqueous HF on the surface of the semiconductor wafers; and **in that**
- the semiconductor wafers are subsequently thermally oxidized.

## Revendications

1. Procédé en vue du traitement chimique de plaquettes de semi-conducteurs pour leur conditionnement avant une oxydation thermique, avec les étapes suivantes:
- le traitement des plaquettes de semi-conducteurs à l'aide d'une solution aqueuse de HF;
- la séparation des plaquettes de semi-conducteurs traitées à l'aide de HF du bain aqueux de HF et ensuite
- le traitement des plaquettes de semi-conducteurs à l'aide d'une solution aqueuse de O₃ qui contient l'O₃ dans une concentration allant de 1 à 50 ppm;
**caractérisé**
- **en ce que** la solution aqueuse de HF contient le HF dans une concentration de 0,001 à 10% en poids;
- **en ce que** la séparation des plaquettes de semi-conducteurs traitées à l'aide de HF du bain aqueux de HF se fait de telle sorte que les plaquettes de semi-conducteurs traitées sont tirées à une vitesse de 0,01 à 15 mm par seconde à travers la surface de la solution aqueuse de HF, de manière à ce qu'aucun HF aqueux ne se trouve plus sur la surface des plaquettes de semi-conducteurs ; et
- **en ce que** les plaquettes de semi-conducteurs sont ensuite oxydées par voie thermique.
